# EUROPEAN PATENT APPLICATION

(11) **EP 3 767 668 A1**
(43) Date of publication of application: **20.01.2021**
(21) Application number: 19187135.9
(22) Date of filing: 18.07.2019
(51) Int. Cl.: H01L 21/368

(54) **METHOD FOR PREPARING A SEMICONDUCTOR STRUCTURE ON A SUBSTRATE**

(71) Applicant: Universität Konstanz, 78464 Konstanz (DE)
(72) Inventor: Wang, Wei, 78464 Konstanz (DE); Schmidt-Mende, Lukas, 78464 Konstanz (DE)
(74) Representative: Kordel, Mattias

(57) **Abstract**

The invention is related to a method for preparing a semiconductor structure (16) on a substrate (10), comprising:
a) depositing a metal-organic precursor solution on a substrate (10) and forming a precursor surface (12);
b) heating the precursor surface (12) locally along a predetermined pattern;
c) rinsing the precursor surface (12) with at least one organic solvent;
d) annealing the rinsed precursor surface (12) at an elevated temperature, and
e) obtaining a metal chalcogenide semiconductor structure (16) or a metalloid chalcogenide semiconductor structure (16).

## Description

The invention relates to a method for preparing a semiconductor structure on a substrate and to a device comprising a semiconductor structure on a substrate.

One of the most widely used methods for preparing small structures, in particular nanometer scale structures on substrates, is electron beam lithography. However, conventional resist based electron beam lithography technologies require time-consuming multi step processes and make use of expensive deposition instruments. Due to the proximity effect and charge back scattering, the resists which are typically used are primary factors limiting the resolution of conventional electron beam lithography methods. The high costs in particular associated with conventional electron beam lithography for preparing semiconductor structures prevents the use of the related methods for low throughput applications. Further, chemicals used in conventional methods are typically hazardous or even toxic.

It is therefore an object of the invention to provide a method for preparing semiconductor structures on substrates and a device comprising a semiconductor structure on a substrate which overcome at least some of the above-mentioned problems to at least some extent.

This object is achieved by providing the present technical teachings, in particular the teachings of the independent claims as well as the embodiments disclosed in the dependent claims and the specification.

The object is in particular achieved by providing a method for preparing a semiconductor structure on a substrate, which comprises the following steps: a) a metal-organic precursor solution is deposited on a substrate, and thus a precursor surface is formed; b) the precursor surface is locally heated along a predetermined pattern; c) the precursor surface is rinsed with at least one organic solvent; d) the rinsed precursor surface is annealed at an elevated temperature, and e) a metal chalcogenide semiconductor structure or a metalloid chalcogenide semiconductor structure is obtained on the substrate. In particular, the metal or metalloid chalcogenide semiconductor structure is obtained directly from the precursor surface after the local heating, rinsing and annealing steps. This means that the present method does not require any further etching or depositing steps beyond the structuring of the precursor surface by local heating along the predetermined pattern. Thus, the present method is a method of direct patterning of the semiconductor structure on the substrate.

Therefore, the method suggested here is extremely versatile, facile and inexpensive, and can easily be applied for fabrication of high performance devices. In particular, it does not require mass production and thus solves the low throughput problem. In particular, since the semiconductor structure is directly obtained from the precursor solution, the method does not rely on a resist, which makes the present method faster and simpler than conventional methods. Moreover, expensive deposition methods, such as chemical vapour deposition, thermal evaporation and magnetron sputtering, are not necessary. Instead, cheap and fast solution processing is possible. The present method requires much less steps than conventional methods, which largely improves efficiency and yield. As the semiconductor material is directly patterned, the method can be optimized very easily.

Local heating of the precursor surface induces local phase transitions in the precursor surface. Due to the phase transitions, the area or regions exposed to local heating in step b) preferably remain on the substrate during the rinsing step c), while the other parts of the precursor surface, which are not locally heated in step b) are removed in the rinsing step c). Thus, step c) is a development process, wherein non-exposed areas of the precursor surface or precursor film are rinsed off, whereas exposed areas are maintained on the substrate since they are insoluble in the rinsing organic solvent, thereby leaving the designed pattern on the substrate. The final structures composed of semiconductor materials are obtained in step e) after final crystallisation at elevated temperatures in the annealing step d).

That the precursor surface is formed in step a) does in particular mean that a precursor film is formed by depositing the metal-organic precursor solution on the substrate. In particular, the precursor solution is not deposited on the substrate in form of a structured pattern. The precursor solution preferably covers an area as a surface or film or coating in a structurally undefined manner. In particular, a layer of the precursor solution is deposited on the substrate, thus forming the precursor surface or precursor film. In particular, the precursor solution is coated on the substrate.

In particular, the precursor solution comprises at least one metal source or metalloid source, preferably at least one organometallic complex comprising at least one metal or at least one metalloid.

Preferably, the at least one organometallic complex is obtained from a metal compound or from a metalloid compound, in particular from a metal chalcogenide or metal hydroxide, or a metalloid chalcogenide or metalloid hydroxide. The respective chalcogenide, which is designated as first chalcogenide for the sake of clarity, is preferably another chalcogenide than the chalcogenide finally obtained in step e), designated as second chalcogenide. In particular, the first chalcogenide from which the organometallic complex is obtained is preferably an oxide. The organometallic complex is preferably obtained by dissolving the metal compound or the metalloid compound in an organic solvent, hereafter designated as second organic solvent, in order to distinguish this second organic solvent from the organic solvent used in the rinsing step c), which is hereafter designated as a first organic solvent.

The precursor solution further comprises at least one chalcogenide source, comprising the second chalcogenide. This chalcogenide source is preferably a sulphur source. The second chalcogenide obtained in step e) is preferably a sulphide. The chalcogenide source is preferably the organometallic complex which is also the metal or metalloid source.

That the precursor surface is heated locally in step b) means in particular that the precursor surface is not heated globally, i.e. not in all of its parts, but partially, i.e. in the regions which form the predetermined pattern. That the precursor surface is heated locally along a predetermined pattern in step b) in particular means that the precursor surface is heated in at least one predetermined region or along at least one predetermined path, in particular in at least a plurality of predetermined regions, or along a plurality of predetermined paths. Thus, the precursor surface is structured, and a desired structure or pattern is written on the surface by local heating. A predetermined region is preferably a predetermined area.

Preferably, the precursor surface or precursor film is heated in step b) locally above a temperature of 300 °C.

That the rinsed precursor surface is annealed at an elevated temperature in step d) means in particular that the annealing is carried out at a temperature which is higher than standard room temperature, in particular higher than 25 °C, in particular higher than 100 °C. Preferably the rinsed precursor surface is annealed in step d) for a predetermined annealing time.

In a preferred embodiment, the precursor solution is deposited on the substrate in step a) by spin coating. This is a fast, easy and inexpensive process for depositing the precursor solution on the substrate in order to form a precursor surface or precursor film. Particularly, the thickness of the precursor surface or precursor film, respectively, is preferably determined by at least one of the speed of a spin coater used for spin coating the precursor solution on the substrate, and the concentration of the precursor solution, in particular the concentration of the organometallic complex in the precursor solution.

In a preferred embodiment, the metal or metalloid semiconductor structure is at least locally obtained with a width - preferably local - of at most 50 nm, preferably at most 40 nm, preferably at most 30 nm, preferably at most 20 nm, preferably less than 20 nm. The method presented here is readily capable of providing semiconductor structures on the nanometer scale, in particular, also in the sub-20 nm range.

In particular, a width is a measure taken in a plane parallel to the precursor surface or parallel to an upper surface of the substrate, preferably a measure taken orthogonal to the predetermined path or orthogonal to a direction of the longest extension of the predetermined region. In particular, the width is the measure taken - preferably locally - along the direction of the smallest extension of the structure, preferably of the predetermined path or region.

In a preferred embodiment, the heating of the precursor surface in step b) is carried out by a process selected from a group consisting of: electron beam irradiation, in particular electron beam lithography; manipulation with an AFM tip, in particular manipulation with a heated AFM tip, in particular scanning probe lithography; and laser beam irradiation, in particular laser heating, in particular laser lithography, in particular laser interference lithography or multiphoton laser lithography. The processes identified here are in particular capable of producing sub-µm structures, in particular on a scale of a few 10 nm, particularly sub-20 nm structures.

In a preferred embodiment, the present method is a method of electron beam direct writing (EBDW), i.e. a method, in which a desired pattern is directly written by an electron beam on a desired material. After direct writing, the desired structure is directly obtained from the exposed part of the precursor surface by rinsing off the non-exposed parts, and annealing the remaining parts of the precursor surface.

The electron beam irradiation is preferably carried out with an acceleration voltage of at least 15 keV to at most 45 keV, preferably at least 20 keV to at most 40 keV, preferably at least 25 keV to at most 35 keV, preferably at 30 keV. The electron dose is preferably set to from at least 3000 µC/cm² to at most 40000 µC/cm².

An AFM tip is a tip of an atomic force microscope (AFM). That the AFM tip is heated means in particular that the AFM tip is heated above standard room temperature, in particular above 25 °C, in particular above 100 °C. Most preferably, the AFM tip is heated above 300 °C.

Multiphoton laser lithography is a technology which uses a focused laser beam to carry out a lithography process. The laser beam is preferably focused by a microscopy objective. The multiphoton laser lithography is preferably carried out with a laser power of at least 14 mW to at most 28 mW. The writing speed of the laser lithography is preferably set to at least 50 µm/s to at most 500 µm/s.

In a preferred embodiment, the precursor solution of step a) is obtained by dissolving at least one metal compound or at least one metalloid compound in an organic dithiocarbamate solution. Particularly, the second organic solvent is a dithiocarbamate solution. Preferably, the precursor solution is obtained by dissolving at least one metal oxide or metal hydroxide, or at least one metalloid oxide or metalloid hydroxide, in an organic dithiocarbamate solution. Such a solution is able to dissolve various types of metal/metalloid hydroxides and/or oxides, and form organometallic complexes comprising the at least one metal or metalloid. Thus, a variety of metal-organic precursor solutions can easily be formed.

In particular, by dissolving the at least one metal compound or metalloid compound in the organic dithiocarbamate solution, a metal-dithiocarbamate-complex or a metalloid-dithiocarbamate-complex is obtained. Local heating of the precursor solution then leads to a decay of the complex, wherein a metal-sulphur-compound or a metalloid-sulphur-compound is formed. In the annealing step d), a metal-sulphur-semiconductor-compound, or a metalloid-sulphur-semiconductor-compound is obtained.

Preferably, in the precursor solution, a Sb-complex, namely antimony butyldithiocarbamate is formed. This complex is thermally decomposed by local heating to partially form crystalline Sb₂S₃, which can further be crystallized in the annealing step.

In a preferred embodiment, the organometallic complex comprised by the metal-organic solution of step a) is obtained from a metal compound or from a metalloid compound, which is a metal chalcogenide or a metalloid chalcogenide, or an oxide or a hydroxide, or is selected from a group consisting of: Sb₂O₃, ZnO, PbO, In(OH)₃, Cd(OH)₂, Cu₂O, SnO, and MnO.

In a preferred embodiment, the organic dithiocarbamate solution comprises an alcohol, preferably as a solvent, preferably ethanol.

Preferably, the organic dithiocarbamate solution comprises at least one dithiocarbamate, in particular according to the formula: 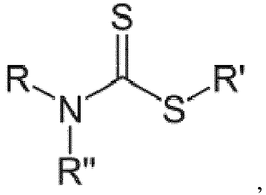 wherein R, R', R" are selected from a group consisting of hydrogen and an alkyl radical. Preferably, R' is hydrogen. The dithiocarbamate is preferably dithiocarbamic acid.

Preferably, R and R' are hydrogen and R" is an alkyl radical, preferably a butyl radical. The dithiocarbamate is preferably butyldithiocarbamic acid. Most preferably, R" is an n-butyl radical. The dithiocarbamate is preferably n-butyldithiocarbamate.

In another embodiment, R' is hydrogen and R and R" are both alkyl radicals, preferably both butyl radicals, in particular both n-butyl radicals. The dithiocarbamate is preferably dibutyldithiocarbamic acid, preferably di-n-butyldithiocarbamic acid.

Preferably, the at least one dithiocarbamate comprised by the organic dithiocarbamate solution is butyldithiocarbamate, most preferably n-butyldithiocarbamate, and the organic dithiocarbamate solution comprises an alcohol, preferably ethanol, preferably as a solvent.

Preferably, the organic dithiocarbamate solution is prepared by adding an amine, in particular a primary amine or a secondary amine, preferably butylamine or n-butylamine, or dibutylamine, preferably di-n-butylamine, to a solution of carbon disulphide in an alcohol, in particular ethanol. By adding an amine to a solution of carbon disulphide in an alcohol, in particular ethanol, a dithiocarbamate, in particular dithiocarbamic acid, is formed.

Dissolving a metal oxide or metalloid oxide or a metal hydroxide or a metalloid hydroxide, in a dithiocarbamic acid solution leads to the formation of a metal-dithiocarbamate-complex or a metalloid-dithiocarbamate-complex.

In a preferred embodiment, the metal chalcogenide semiconductor structure or the metalloid chalcogenide semiconductor structure obtained in step e) is a metal sulphide semiconductor structure or metalloid sulphide semiconductor structure. In particular, the metal chalcogenide semiconductor structure or a metalloid chalcogenide semiconductor structure obtained in step e) comprises at least one semiconductor selected from a group consisting of: Sb₂S₃, ZnS, PbS, InS, CdS, SnS, CuS, and MnS.

In a preferred embodiment, a selenium chalcogenide is added to the precursor solution prior to step a). In this respect, selenium doping can easily be performed for the chalcogenide semiconductor structures by simply adding the selenium chalcogenide prior to step a) to the precursor solution. Accordingly, in step e) preferably a metal chalcogenide semiconductor structure or a metalloid chalcogenide semiconductor structure is obtained, which comprises most preferably a formula in accordance with the formulae: MeS₁₋ₓSeₓ, wherein preferably Me is Zn, Pb, In, Cd, Sn, Cu, or Mn, and Me₂S₃₋ₓSeₓ, wherein Me preferably is Sb.

Preferably, the selenium chalcogenide added to the precursor solution prior to step a) is selenium oxide (SeO₂).

In a preferred embodiment, the annealing step b) is carried out at a temperature of at least 250 °C to at most 600 °C, preferably at least 300 °C to at most 550 °C.

Preferably, the annealing step d) is carried out at a temperature of 300 °C, in particular for obtaining a Sb₂S₃/Sb₂S₃₋ₓSeₓ semiconductor structure. Alternatively, the annealing step d) is preferably carried out at 550 °C, in particular for a ZnS/ZnS₁₋ₓSeₓ semiconductor structure.

In the annealing step d), particularly the metal-organic complex is decomposed and residual organic solvent is removed.

The annealing of step d) is preferably carried out for an annealing time of at least 20 min to at most 40 min, preferably at least 25 min to at most 35 min, preferably 30 min.

In a preferred embodiment the at least one organic solvent of step e) is selected from a group consisting of: acetone and isopropanol. Particularly, the rinsing of step c) is preferably carried out by immersion of the precursor surface in the first organic solvent for a predetermined rinsing time, preferably for one hour. Preferably, the precursor surface is immersed for one hour in isopropanol or in acetone.

In a preferred embodiment, the rinsed precursor surface obtained in step c) is blown at by a stream of gas prior to step d). This advantageously removes residual moisture, in particular residual organic solvent, prior to the annealing of step d).

Preferably, nitrogen is used as the gas for applying the gas stream, in particular in order to remove residual moisture of the rinsed precursor surface prior to step d).

In a preferred embodiment, the substrate is selected from a group consisting of: silicon, silicon-dioxide, F-doped tin oxide (FTO) glass, and a field-effect transistor (FET) chip. Particularly, the substrate may be a silicon wafer.

In a preferred embodiment, the steps a) to e) are repeated with or on the same substrate in order to obtain at least one 3-dimensional chalcogenide semiconductor structure or at least one metalloid chalcogenide semiconductor structure. Thus, the present method is not confined to two dimensions; rather, 3-dimensional structures, in particular 3-dimensional nanostructures, can be fabricated by multiply applying the steps of direct patterning defined above. Preferably, multiple layers of metal chalcogenide semiconductor structures or metalloid chalcogenide semiconductor structures are built upon each other. Particularly, by repeatedly carrying out step a), the precursor solution is deposited at least partially on an existing semiconductor structure obtained in a prior iteration of steps a) to e). Thus, a 3-dimensional semiconductor structure can be built layer by layer.

The present method may preferably be used for preparing semiconductor structures in the fields of microfluidics, display units, nano/micro electronics systems, optoelectronic devices, solar cells, and computer chips.

The object is also achieved by providing a device comprising a semiconductor structure on a substrate, obtainable by, preferably obtained by, the method according to the invention or a preferred embodiment of this method as explained above.

The device is preferably a microfluidic device, a display unit or display, a nano/micro electronic system, an optoelectronic device, a solar cell, and a computer chip.

In a preferred embodiment, the precursor solution of step a) is obtained by dissolving an antimony compound in a n-butyldithiocarbamate solution and preferably the heating in step b) is carried out by an electron beam irradiation process.

In connection with the present invention, the term "n-butyldithiocarbamate solution" is to be understood as an organic dithiocarbamate solution comprising n-butyldithiocarbamate.

In a preferred embodiment, the precursor solution of step a) is obtained by dissolving an antimony compound in a n-butyldithiocarbamate solution and preferably the heating in step b) is carried out by a manipulation with an AFM tip.

In a preferred embodiment, the precursor solution of step a) is obtained by dissolving an antimony compound in a n-butyldithiocarbamate solution and preferably the heating in step b) is carried out by a laser lithography process.

In a preferred embodiment, the precursor solution of step a) is obtained by dissolving an antimony compound in a di-n-butyldithiocarbamate solution and preferably the heating in step b) is carried out by an electron beam irradiation process.

In connection with the present invention, the term "di-n-butyldithiocarbamate solution" is to be understood as an organic dithiocarbamate solution comprising di-n-butyldithiocarbamate.

In a preferred embodiment, the precursor solution of step a) is obtained by dissolving an antimony compound in a di-n-butyldithiocarbamate solution and preferably the heating in step b) is carried out by a manipulation with an AFM tip.

In a preferred embodiment, the precursor solution of step a) is obtained by dissolving an antimony compound in a di-n-butyldithiocarbamate solution and preferably the heating in step b) is carried out by a laser lithography process.

In a preferred embodiment, the precursor solution of step a) is obtained by dissolving a zinc compound in a n-butyldithiocarbamate solution and preferably the heating in step b) is carried out by an electron beam irradiation process.

In a preferred embodiment, the precursor solution of step a) is obtained by dissolving a zinc compound in a n-butyldithiocarbamate solution and preferably the heating in step b) is carried out by a manipulation with an AFM tip.

In a preferred embodiment, the precursor solution of step a) is obtained by dissolving a zinc compound in a n-butyldithiocarbamate solution and preferably the heating in step b) is carried out by a laser lithography process.

In a preferred embodiment, the precursor solution of step a) is obtained by dissolving a zinc compound in a di-n-butyldithiocarbamate solution and preferably the heating in step b) is carried out by an electron beam irradiation process.

In a preferred embodiment, the precursor solution of step a) is obtained by dissolving a zinc compound in a di-n-butyldithiocarbamate solution and preferably the heating in step b) is carried out by a manipulation with an AFM tip.

In a preferred embodiment, the precursor solution of step a) is obtained by dissolving a zinc compound in a di-n-butyldithiocarbamate solution and preferably the heating in step b) is carried out by a laser lithography process.

In a preferred embodiment, the precursor solution of step a) is obtained by dissolving a lead compound in a n-butyldithiocarbamate solution and preferably the heating in step b) is carried out by an electron beam irradiation process.

In a preferred embodiment, the precursor solution of step a) is obtained by dissolving a lead compound in a n-butyldithiocarbamate solution and preferably the heating in step b) is carried out by a manipulation with an AFM tip.

In a preferred embodiment, the precursor solution of step a) is obtained by dissolving a lead compound in a n-butyldithiocarbamate solution and preferably the heating in step b) is carried out by a laser lithography process.

In a preferred embodiment, the precursor solution of step a) is obtained by dissolving a lead compound in a di-n-butyldithiocarbamate solution and preferably the heating in step b) is carried out by an electron beam irradiation process.

In a preferred embodiment, the precursor solution of step a) is obtained by dissolving a lead compound in a di-n-butyldithiocarbamate solution and preferably the heating in step b) is carried out by a manipulation with an AFM tip.

In a preferred embodiment, the precursor solution of step a) is obtained by dissolving a lead compound in a di-n-butyldithiocarbamate solution and preferably the heating in step b) is carried out by a laser lithography process.

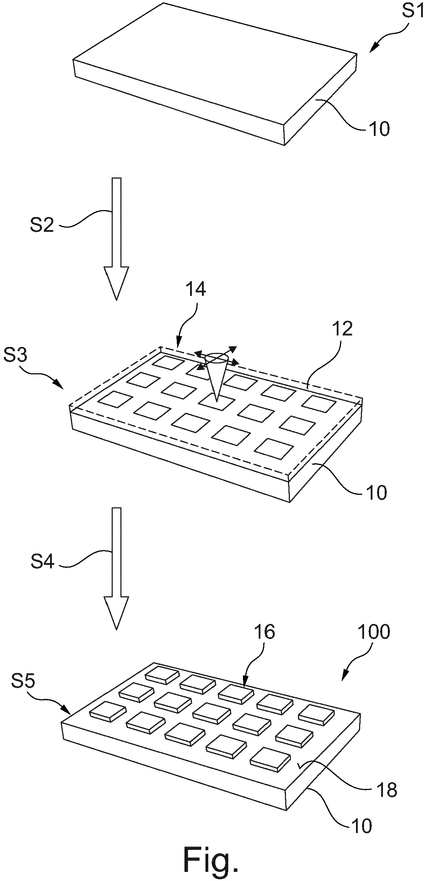

The invention is further explained with respect to the following examples and the drawing, in which the only
- Figure: shows an embodiment of a method for preparing a semiconductor structure on a substrate.

### First Example

In a first example of the present method, the metal-organic precursor solution is prepared by the following steps: 2.0 mmol of antimony (III) oxide (Sb₂O₃), 4.0 mL of ethanol and 3 mL of carbon disulphide (CS₂) are added into a 50 mL three-neck vial with magnetic stirring at room temperature. 4 mL n-butylamine is slowly injected into the vial and the mixture is continuously stirred for 12 hours, resulting in a homogenous solution. 1 mL of this solution is diluted with 2 mL ethanol to obtain the precursor solution. The precursor solution is spin coated on a substrate. Particularly, a 100 nm thick Sb₂S₃ precursor film is obtained by spin coating the precursor solution at a speed of 8000 rpm for 30 s. The high-speed spin coating ensures the formation of a homogenously covered and pinhole free Sb₂S₃ precursor film. The 100 nm thick spin coated film on the substrate is directly transferred into an electron beam lithography system for electron beam patterning. Electron beam patterning as the heating step b) of the present method is carried out with a dose of 30000 µC/cm² at 20 keV. Afterwards, rinsing of the precursor surface in step c) is carried out by immersion in acetone for one hour. Afterwards, the rinsed precursor surface is dried with nitrogen gas. The annealing of step d) is carried out at 300 °C. As a result, a Sb₂S₃ semiconductor structure is obtained.

### Second Example

In a second example of the present method, the precursor solution is prepared by the following steps: 2.0 mmol of antimony (III) oxide (Sb₂O₃), 20 mg of selenium oxide (SeO₂), 4.0 mL of ethanol and 3 mL of carbon disulphide (CS₂) are added into a 50 mL 3-neck vial with magnetic stirring at room temperature. 4 mL n-butylamine is slowly injected into the vial and the mixture is continuously stirred for 12 hours for obtaining a homogenous solution. In order to obtain the precursor solution for step a) of the present method, 1 mL of this homogenous solution is diluted with 2 mL ethanol. The precursor solution is spin coated on a substrate. Particularly, a 100 nm thick precursor film is obtained by spin coating the diluted solution at a speed of 8000 rpm for 30 s. The 100 nm thick spin coated precursor film on the substrate is directly transferred into an electron beam lithography system for electron beam patterning. The electron beam patterning is carried out with a dose of 30000 µC/cm² at 20 keV. After electron beam patterning, the precursor surface is rinsed by immersion for one hour in acetone. Afterwards, the rinsed precursor surface is dried with nitrogen gas and annealed at 300 °C. Thereby, a Sb₂S₃₋ₓSeₓ semiconductor structure is obtained.

### Figure

The only figure shows an embodiment of a method for preparing a semiconductor structure on a substrate.

In a first step S1 a substrate 10 is provided. The substrate 10 is preferably selected from a group consisting of silicon, particularly a silicon wafer, silicon dioxide, F-doped tin oxide glass, and a field effect transistor chip.

In a second step S2 a metal-organic precursor solution is deposited, preferably spin coated, on the substrate 10, such that a precursor surface 12 or precursor film is formed.

In a third step S3 the precursor surface 12 is locally heated along a predetermined pattern 14, preferably in at least one predetermined region or along at least one predetermined path. The heating is preferably carried out by a process selected from a group consisting of electron beam irradiation, manipulation with an AFM tip, particularly with a heated AFM tip, and laser heating.

In a fourth step S4, the locally heated precursor surface is rinsed with at least one organic solvent, preferably acetone or isopropanol; further, the rinsed precursor surface is annealed at an elevated temperature, preferably at a temperature of at least 250 °C to at most 600 °C, preferably at 300 °C or at 550 °C.

In a fifth step S5, a metal chalcogenide semiconductor structure or a metalloid chalcogenide semiconductor structure, generally a semiconductor structure 16, is obtained, wherein the semiconductor structure 16 preferably has - at least locally - a width of at most 50 nm, preferably at most 40 nm, preferably at most 30 nm, preferably at most 20 nm, preferably less than 20 nm. Thus, a device 100 is obtained, the device 100 comprising the semiconductor structure 16 on the substrate 10.

In the embodiment shown here, the semiconductor structure 16 comprises a regular pattern of squares, equally distributed on an upper surface 18 of the substrate 10. Preferably, the squares have an edge length of less than 20 nm.

The precursor solution is preferably obtained by dissolving at least one metal compound or metalloid compound, in particular a metal chalcogenide or metalloid chalcogenide, in an organic dithiocarbamate solution.

Preferably, an organometallic complex comprised by the precursor solution is obtained from a metal or metalloid compound, which is a metal chalcogenide or metalloid chalcogenide, in particular metal oxide or metalloid oxide, or from a metal hydroxide or metalloid hydroxide, or is selected from a group consisting of: Sb₂O₃, ZnO, PbO, In(OH)₃, Cd(OH)₂, Cu₂O, SnO, and MnO.

Preferably, the organic dithiocarbamate solution comprises an alcohol, preferably ethanol, preferably as a solvent, and at least one dithiocarbamate, preferably butyldithiocarbamate, most preferably n-butyldithiocarbamate, wherein the organic dithiocarbamate solution is preferably prepared by adding an amine, in particular a primary amine or a secondary amine, to a solution of carbon disulphide in an alcohol, preferably ethanol.

Preferably, the metal chalcogenide semiconductor structure or the metalloid chalcogenide semiconductor structure comprises at least one semiconductor selected from a group consisting of: Sb₂S₃, ZnS, PbS, InS, CdS, SnS, CuS, and MnS.

Preferably, a selenium chalcogenide, particularly selenium oxide, is added to the precursor solution prior to depositing the precursor solution on the substrate, in particular for direct Se doping.

Preferably, the rinsed precursor surface is blown at by a stream of gas, in particular a stream of nitrogen, prior to the annealing step.

Preferably, the steps of depositing the precursor solution, locally heating the precursor surface, rinsing the precursor surface, annealing the rinsed precursor surface, and obtaining the semiconductor structure 16 are repeated with or on the substrate 10 at least twice, preferably more than twice, in order to obtain at least one 3-dimensional metal chalcogenide semiconductor structure or metalloid chalcogenide semiconductor structure, in general a 3-dimensional semiconductor structure 16. For example, further squares or other structures can be built upon the squares of the semiconductor structure 16 shown in the figure.

## Claims

1. Method for preparing a semiconductor structure (16) on a substrate (10), comprising:
a) depositing a metal-organic precursor solution on a substrate (10) and forming a precursor surface (12);
b) heating the precursor surface (12) locally along a predetermined pattern;
c) rinsing the precursor surface (12) with at least one organic solvent;
d) annealing the rinsed precursor surface (12) at an elevated temperature, and
e) obtaining a metal chalcogenide semiconductor structure (16) or a metalloid chalcogenide semiconductor structure (16) on the substrate (10).

2. Method according to claim 1, wherein the precursor solution is deposited on the substrate (10) in step a) by spin coating.

3. Method according to any of the preceding claims, wherein the metal or metalloid semiconductor structure (16) is at least locally obtained with a width of at most 50 nm, preferably at most 40 nm, preferably at most 30 nm, preferably at most 20 nm, preferably less than 20 nm.

4. Method according to any of the preceding claims, wherein the heating of the precursor surface (12) in step b) is carried out by a process selected from a group consisting of: electron beam irradiation, manipulation with an AFM tip, and laser beam irradiation, in particular laser heating, in particular laser lithography, in particular laser interference lithography or multiphoton laser lithography.

5. Method according to any of the preceding claims, wherein the precursor solution of step a) is obtained by dissolving at least one metal compound or metalloid compound in an organic dithiocarbamate solution.

6. Method according to any of the preceding claims, wherein the metal-organic precursor solution of step a) comprises an organometallic complex obtained from a metal or metalloid compound, which is a chalcogenide, or an oxide or a hydroxide, or is selected from a group consisting of: Sb₂O₃, ZnO, PbO, In(OH)₃, Cd(OH)₂, Cu₂O, SnO, and MnO.

7. Method according to any of the preceding claims, wherein the organic dithiocarbamate solution comprises an alcohol, preferably ethanol, preferably as a solvent and at least one dithiocarbamate, preferably butyldithiocarbamate, most preferably n-butyldithiocarbamate, wherein the organic dithiocarbamate solution is preferably prepared by adding an amine to a solution of carbon disulphide in ethanol.

8. Method according to any of the preceding claims, wherein the metal chalcogenide semiconductor structure (16) or the metalloid chalcogenide semiconductor structure (16) obtained in step e) comprises at least one semiconductor selected from a group consisting of: Sb₂S₃, ZnS, PbS, InS, CdS, SnS, CuS, and MnS.

9. Method according to any of the preceding claims, wherein a selenium chalcogenide is added to the precursor solution prior to step a).

10. Method according to any of the preceding claims, wherein the annealing of step d) is carried out at a temperature of at least 250 °C to at most 600 °C, preferably at least 300 °C to at most 550 °C, preferably at 300 °C, preferably at 550 °C.

11. Method according to any of the preceding claims, wherein the at least one organic solvent of step e) is selected from a group consisting of: acetone and isopropanol.

12. Method according to any of the preceding claims, wherein the rinsed precursor surface is blown at by a stream of gas prior to step d).

13. Method according to any of the preceding claims, wherein the substrate (10) is selected from a group consisting of: silicon, silicon dioxide, F-doped tin oxide glass, and a FET chip.

14. Method according to any of the preceding claims, wherein the steps a) to e) are repeated to obtain at least one 3-dimensional metal chalcogenide semiconductor structure (16) or metalloid chalcogenide semiconductor structure (16).

15. Device (100), comprising a semiconductor structure (16) on a substrate (10), obtainable by a method according to any one of claims 1 to 14.
